# EUROPEAN PATENT APPLICATION

(11) **EP 1 167 417 A1**
(43) Date of publication of application: **02.01.2002**
(21) Application number: 00901913.4
(22) Date of filing: 26.01.2000
(51) Int. Cl.: C08G 59/14, C08F 290/06, B32B 15/08, C08J 5/24, C09D 163/10

(54) **FLAME-RETARDANT VINYL ESTERS, RESINS AND RESIN COMPOSITIONS CONTAINING THE SAME, AND CURED PRODUCTS THEREOF**

(30) Priority: 28.01.1999 JP 1980399; 08.02.1999 JP 3063499; 30.08.1999 JP 24395699; 30.08.1999 JP 24395599
(71) Applicant: TAKEDA CHEMICAL INDUSTRIES, LTD., Osaka-fu 540-8645 (JP)
(72) Inventor: OKUMURA, Hiroya Takeda Chemical Industries, Ltd., Yodogawa-ku Osaka-shi, Osaka 532-8686 (JP); UCHIDA, Toshiaki Takeda Chemical Industries, Ltd., Yoddogawa-ku Osaka-shi, Osaka 532-8686 (JP); TAKEUCHI, Hiroshi Takeda Chemical Industries Ltd., Yodogawa-ku Osaka-shi, Osaka 532-8686 (JP)
(74) Representative: von Kreisler, Alek, Dipl.-Chem.
(86) International application number: JP0000393
(87) International publication number: WO0044805

(57) **Abstract**

A flame retardant vinyl ester is obtained by either causing reaction of a compound (A) having epoxy groups with a cyclic phosphoric acid compound represented with 9,10-dihydro-9-oxa-10-phosphaphenanthrene-10-oxide while controlling the P-H group/epoxy group ratio to be 0.01 to 0.7 and then reacting the remaining epoxy groups with an ethylenically unsaturated monobasic acid (B), or reacting (A) with (B) and then further reacting the ethylenically unsaturated groups with the phosphorus compound while controlling the P-H group/epoxy group ratio to be 0.01 to 0.7 and having the phosphorus content of 0.1 to 6 % by weight and the double bond equivalent of 200 to 1000 g/mol. Although being free from halogen, the flame retardant vinyl ester can provide a cured product with high flame retardance, heat resistance, moisture-proofness and excellent mechanophysical properties and usable for a layered plate and a resist ink.

## Description

### FIELD OF THE INVENTION

The present invention relates to a halogen-free vinyl ester which can provide cured products excellent in flame retardance, a resin containing it, a resin composition containing the resin and a cured product thereof.

### PRIOR ART OF THE INVENTION

Recently, a photo- or thermo-setting resin having unsaturated bonds such as vinyl ester resin, unsaturated polyester resin and the like has been used in a wide range of industrial fields owing to its excellent heat resistance, mechanical properties, electrical characteristics and the like. Making such resin be flame retardant has conventionally been achieved by using a halogen type flame retardant or by introducing halogen atoms into molecules of the resin. However, as concerns for environmental problems have been increased, it becomes difficult to use a cured product of resin containing halogens attributed to that such a resin becomes a source of dioxins at the time of combustion.

As a substitution technique, discussed is to make resin using elements such as phosphorus, antimony and the like be flame retardant. However, since the resin such as foregoing vinyl ester resin is generally used together with a reactive diluent such as styrene, methyl methacrylate and the like, making such parts flame retardant is difficult and therefore a large amount of a flame retardant is required to add. Further, such flame retardants are not introduced in the molecules of the resin, so that their addition in a large amount results in deterioration of mechanical properties of a cured product of the resin.

Furthermore, many of phosphorus type flame retardants have phosphorous acid ester structure and a phosphorous acid ester has substantially a high moisture absorptive property and a low heat resistance, so that such flame retardants possibly decrease heat resistance and moisture-proofness of the cured product. Hence, resin having unsaturated bonds and a resin composition which are free from halogen, possible to provide a cured product excellent in flame retardance, heat resistance, moisture-proofness, and mechanical properties and excellent in productivity has not yet been made available. Further, even if it is used as a photo-curable resin using no styrene, the phosphorus type flame retardants deteriorate the photo-curable property and consequently make it impossible to obtain a cured product having expected heat resistance and mechanical properties and furthermore, they deteriorate the foregoing humidity-proofness and they are thus unsatisfactory.

### DISCLOSURE OF THE INVENTION

The objects of the present invention are to provide a vinyl ester excellent in productivity and possible to provide a cured product having a high flame retardance even though it is halogen-free, excellent properties such as heat resistance, moisture-proofness, and mechanical properties, resin containing such a vinyl ester, a composition containing the resin, and a cured product thereof.

In order to solve the forgoing problems on a conventional technique, inventors of the present invention have enthusiastically investigated and found that a vinyl ester whose molecules are adducted with a specified phosphorus compound and a vinyl ester having a structure formed by further addition of polybasic acid anhydride to the former vinyl ester in molecules are possible to provide cured products showing extremely excellent results in a severe high temperature moisture resistance test such as a pressure cooker test (PCT) and that the vinyl esters can provide cured products having high flame retardance with a phosphorus content lower than a conventional level.

The inventors thus complete the present invention. The present invention comprises:

Flame retardant vinyl ester containing 0.1 to 6% of phosphorus and 200 to 1000 g/mol double bond equivalent obtained by either reacting a compound (A) having epoxy groups with a phosphorus compound of the formula (1) and/or a phosphorus compound of the formula (2) under conditions as to control P-H group/epoxy group ratio to be 0.01 to 0.7 for the former and OH group/epoxy group ratio to be 0.01 to 0.99 for the latter and the total of P-H group/epoxy group ratio and OH group/epoxy group ratio to be 0.99 or lower for both and then reacting the remaining epoxy groups with an ethylenically unsaturated monobasic acid (B) or reacting (A) with (B) and then further reacting the ethylenically unsaturated groups with the phosphorus compound having the formula (1) while controlling the P-H group/double bond ratio to be 0.01 to 0.7, the formula (1) is;
1) 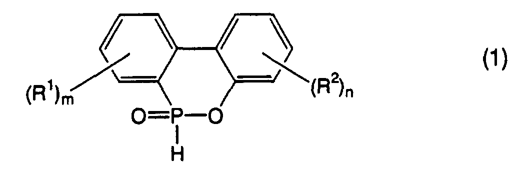 wherein R¹ and R² are the same or different, and separately denote an aliphatic or aromatic group; and the symbols m and n are respectively an integer of 0 to 4, and the formula (2) is; 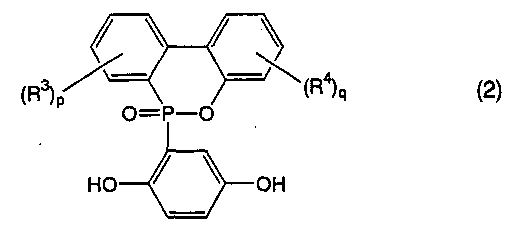 wherein R³ and R⁴ are the same or different, and separately denote an aliphatic or aromatic group; and the symbols p and q are respectively an integer of 0 to 4.:
2) The flame retardant vinyl ester according to 1) obtained by reacting the compound (A) with the phosphorus compound of the formula (1) under conditions as to control P-H group/epoxy group ratio to be 0.01 to 0.7 and/or with the phosphorus compound of the formula (2) under conditions as to control OH group/epoxy group ratio to be 0.01 to 0.99 and the total of P-H group/epoxy group ratio and OH group/epoxy group ratio to be 0.99 or lower and then reacting the remaining epoxy groups with the ethylenically unsaturated monobasic acid (B):
3) The flame retardant vinyl ester according to 1) obtained by reacting (A) with (B) and then further reacting the ethylenically unsaturated groups with the phosphorus compound having the formula (1) while controlling the P-H group/double bond ratio to be 0.01 to 0.7:
4) The flame retardant vinyl ester according to 1), 2), or 3), wherein the compound (A) is at least one compound selected from glycidyl (meth)acrylate, bisphenol A type epoxy resin, bisphenol F type epoxy resin, cresol novolak type epoxy resin, and phenol novolak type epoxy resin:
5) The flame retardant vinyl ester according to 1), 2), or 3), wherein the ethylenically unsaturated monobasic acid (B) is either (meth)acrylic acid, or a reaction product of at least one compound selected from hydroxyethyl (meth)acrylate, hydroxylpropyl (meth)acrylate, hydroxybutyl (meth)acrylate with a polybasic acid anhydride:
6)The flame retardant vinyl ester according to 5), wherein the polybasic acid anhydride is maleic anhydride and/or itaconic anhydride:
7) The flame retardant vinyl ester according to 5), wherein the ethylenically unsaturated monobasic acid (B) is (meth)acrylic acid:
8) A flame retardant vinyl ester resin containing the flame retardant vinyl ester according to 1) and a reactive diluent having ethylenically unsaturated bonds:
9) A flame retardant vinyl ester resin composition which comprises 1 to 30 parts by weight of a rubber component to 100 parts by weight in total of the flame retardant vinyl ester according to 1) and a reactive diluent having ethylenically unsaturated bonds:
10) A flame retardant vinyl ester resin composition which comprises 0.1 to 5 parts by weight of a curing agent, not more than 400 parts by weight of a filler relative to 100 parts by weight in total of the flame retardant vinyl ester according to 1) and a reactive diluent having ethylenically unsaturated bonds:
11) A metal foil-laminated layered plate which comprises a reinforcing fiber layer formed by layering the flame retardant vinyl ester resin according to 8) and a metal foil integrally cured together:
12) An acid-adducted flame retardant vinyl ester having a structure in which a polybasic acid anhydride is adducted to at least one of hydroxy groups of the flame retardant vinyl ester according to 1), 2), or 3):
13) A photo-curable and thermosetting resist ink composition containing the acid-adducted flame retardant vinyl ester according to 12), a diluent, a photopolymerization initiator, and a thermosetting component of an epoxy compound having two or more epoxy groups in one molecule and possible to be developed with an alkaline solution.
14) The resist ink composition according to 13) containing the acid-adducted flame retardant vinyl ester according to 12) having an acid value of 45 to 160 mgKOH/g.

The compound (A) having epoxy groups to be employed for the present invention is, for example, bisphenol type epoxy resin represented by bisphenol A type and bisphenol F type as described in Japanese Patent Laid-Open No. Hei 9 - 110948 (e.g. YD128, produced by Tohto Kasei Co., Ltd., epoxy equivalent 187); novolak type epoxy resin represented by phenol novolak (e.g. YDPN638, Tohto Kasei Co., Ltd., epoxy equivalent 180) and cresol novolak (e.g. YDCN702P, Tohto Kasei Co., Ltd., epoxy equivalent 200); aliphatic type epoxy resin; nitrogen-containing epoxy resin (e.g. triglycidyl isocyanurate); and copolymer type epoxy resin and the like, (meth)acrylates having epoxy groups in molecules such as glycidyl (meth)acrylate, methylglycidyl (meth)acrylate, 4-(meth)acryloxymethyl cyclohexene oxide and the like are among examples. Among them, preferable examples are glycidyl (meth)acrylate, bisphenol A type epoxy resin, bisphenol F type epoxy resin, cresol novolak type epoxy resin, phenol novolak type epoxy resin and the like.

Such a compound (A) having epoxy groups may be vinyl-esterified with an ethylenically unsaturated monobasic acid (B) and then some of unsaturated groups in the resultant vinyl ester may be reacted as described later with a phosphorus compound of the formula (1) to obtain flame retardant vinyl ester resin of the present invention and on the other hand, the epoxy groups of the compound (A) are reacted with a phosphorus compound of the formula (1) and/or the formula (2) and then the obtained compound is further reacted with an ethylenically unsaturated monobasic acid (B) to obtain flame retardant vinyl ester resin of the present invention.

Regarding a phosphorus compound of the formula (1) or the formula (2) to be reacted with the epoxy groups of a compound (A) containing epoxy group, examples of the aliphatic groups denoted as R¹ to R⁴ are lower alkyl groups of 1 to 4 carbons such as methyl, ethyl, n-propyl, n-butyl and the like; aromatocarbocyclic groups such as phenyl and naphthyl as aromatic groups.

Among those groups of R¹ to R⁴, the preferable one is phenyl group. The symbols m, n, p and q independently denote an integer from 0 to 4 and preferably 0 or 1. A concrete example of a phosphorus compound of the formula (1) is 9,10-dihydro-9-oxa-10-phosphaphenanthrene-10-oxide (produced by Sanko Chemical Co., Ltd., hereinafter abbreviated as HCA) and a practical example of a phosphorus compound of the formula (2) is 10-(2',5'-dihydroxyphenyl)-9,10-dihydro-9-oxa-10-phosphaphenanthrene-10-oxide (produced by Sanko Chemical Co., Ltd., hereinafter abbreviated as HCAHQ).

The reaction of a phosphorus compound of the formula (1) and a compound (A) having epoxy groups may be carried out in absence of a catalyst at 130 to 250°C, preferably 150 to 230°C, for 1 to 10 hours. The ratio of P-H groups and epoxy groups (P-H group/epoxy group) in the reaction of the compound (A) and the phosphorus compound of the formula (1) is generally 0.01 to 0.7, preferably 0.1 to 0.6.

The reaction of a phosphorus compound of the formula (2) and a compound (A) having epoxy groups may be carried out in absence of a catalyst or in the presence of a catalyst of such as tetraethyl phosphonium acetate at 140 to 180°C for 1 to 5 hours. The ratio of hydroxy groups and epoxy groups (OH group/epoxy group) in the reaction of the compound (A) and the phosphorus compound having the formula (2) is generally 0.01 to 0.99, preferably 0.05 to 0.8.

In case of carrying out the reaction of a compound (A) having epoxy groups with a phosphorus compound having the formula (1) and the formula (2) in combination, the reaction is carried out under conditions as to control the total of the P-H group/epoxy group and the OH group/epoxy group to be 0.99 or lower, preferably 0.1 to 0.8.

As an ethylenically unsaturated monobasic acid (B), examples are unsaturated monocarboxylic acid such as (meth)acrylic acid and other than that, reaction products of polybasic acid anhydrides and (meth)acrylates having alcohol-type hydroxy groups.

Examples of the polybasic acid anhydrides to be used for the forgoing reaction are aliphatic and aromatic dicarboxylic acid anhydrides such as maleic anhydride, itaconic anhydride, succinic anhydride, phthalic anhydride, tetrahydrophthalic anhydride, hexahydrophthalic anhydride and the like and among them, maleic anhydride and itaconic anhydride are preferable.

Examples of the (meth)acrylates having alcohol-type hydroxyl groups are hydroxyethyl (meth)acrylate, hydroxypropyl (meth)acrylate, hydroxybutyl (meth)acrylate, pentaerythritol tri(meth)acrylate, glycerin di(meth)acrylate, and reaction products of (meth)acrylic acid and polyalcohols. Among them, an ethylenically unsaturated monobasic acid (B) is especially preferably (meth)acrylic acid.

The reaction of a compound (A) having epoxy groups with an ethylenically unsaturated monobasic acid (B) can be carried out by a known method and for example, a desired vinyl ester resin can be obtained by carrying out the reaction using a tertiary amine such as benzyldimethylamine, a phosphorous compound such as triphenylphosphine at 80 to 150°C for 1 to 20 hours in the presence of a polymerization inhibitor of such as hydroquinone. The ratio of carboxyl groups and epoxy groups (carboxyl group/epoxy group) in the reaction is generally 0.5 to 1.5, preferably 0.8 to 1.2.

Further, for the purpose of adjusting the viscosity of the reaction solution, a diluent may be used. Usable as a diluent is inactive diluents among known organic solvents, that is, those inactive to epoxy groups and carboxyl groups can be employed with no specific restriction.

Examples of the diluent include lower fatty acid esters such as ethyl acetate, isopropyl acetate and the like; ethylene glycol monoalkyl ether acetates such as cellosolve acetate, butylcellosolve acetate and the like; diethylene glycol monoalkyl ether acetates such as diethylene glycol monomethyl ether acetate, carbitol acetate, butylcarbitol acetate and the like; propylene glycol monoalkyl ether acetates; acetic acid esters such as dipropylene glycol monoalkyl ether acetates; ethylene glycol dialkyl ethers; diethylene glycol dialkyl ethers such as methyl carbitol, ethyl carbitol, butyl carbitol and the like; triethylene glycol dialkyl ethers; propylene glycol dialkyl ethers; dipropylene glycol dialkyl ethers; ethers such as 1,4-dioxane, tetrahydrofuran and the like; ketones such as acetone, methyl ethyl ketone, methyl isobutyl ketone, cyclohexanone, butyrolactone and the like; hydrocarbons such as benzene, toluene, xylene, tetramethylbenzene, tetralin, octane, decane and the like; petroleum type solvents such as petroleum ether, petroleum naphtha, hydrogenated petroleum naphtha, solvent naphtha and the like (e.g. Ipsol 150, produced by Idemitsu Petrochemical Co., Ltd.); and an inactive diluent such as dimethyl formamide and N-methylpyrrolidone.

Addition of a phosphorus compound of the formula (1) to ethylenically unsaturated groups may by carried out by reacting epoxy groups with an ethylenically unsaturated monobasic acid by the foregoing method to obtain a vinyl ester and then, if necessary, further adding a polybasic acid anhydride to the obtained vinyl ester and after that adding a phosphorus compound of the formula (1) without newly adding a catalyst and carrying out the reaction at 100 to 160°C, preferably 110 to 150°C, for 0.1 to 20 hours to obtain a flame retardant vinyl ester resin. Alternatively, a desired flame retardant vinyl ester resin can be obtained by adding a phosphorus compound having the formula (1) to an unsaturated monobasic acid such as (meth)acrylic acid without adding a catalyst and carrying out reaction at 100 to 160°C, preferably 110 to 150°C, for 0.1 to 10 hours to obtain a monobasic acid adducted with the compound of the formula (1) and after that carrying out reaction of the obtained product with epoxy resin in place of some of the ethylenically unsaturated monobasic acid.

The ratio of P-H groups and double bonds (P-H group/double bond) in the reaction of the vinyl ester and the phosphorus compound of the formula (1) is generally 0.01 to 0.7, preferably 0.1 to 0.6.

The flame retardant vinyl ester resin of the present invention contains phosphorus, in generally, 0.1 to 6%, preferably 0.5 to 5%, including the case of an acid-adducted flame retardant vinyl ester, which will be described later. If the phosphorus content exceeds 6%, although a cured product obtained from the flame retardant vinyl ester resin is made highly flame retardant, the moisture absorptivity and the water absorptivity of the product tend to be increased and the mechanical properties tend to be deteriorated. In contrast with that, if the content is lower than 0.1%, it becomes difficult to obtain sufficient flame retardance.

The double bond equivalent in a flame retardant vinyl ester is generally 200 to 1,000 g/mol. If the double bond equivalent is lower than the range, a cured product having an extremely high cross-linking density consequently forms and it becomes a fragile material and difficult to be used in the industries. On the other hand, if the double bond equivalent exceeds the range, it becomes difficult to obtain a resin having sufficiently high cross-linking density and consequently, difficult to obtain a resin having a sufficiently high heat resistance and sufficient mechanical properties. The preferable double bond equivalent of the resin is 300 to 800 g/mol.

Next, a flame retardant vinyl ester resin composition for a laminate plate by the use of the flame retardant vinyl ester resin of the present invention will be described bellow.

For the purpose of lowering the viscosity or the like, the obtained flame retardant vinyl ester is preferable to be used as a flame retardant vinyl ester resin diluted with a reactive diluent containing at least one ethylenically unsaturated bond in one molecule. Examples usable as the reactive diluent are unsaturated aliphatic acids such as acrylic acid, methacrylic acid and the like; unsaturated aliphatic carboxylic acid esters such as methyl methacrylate, ethyl methacrylate, propyl methacrylate, butyl methacrylate, 2-ethylhexyl methacrylate, glycidyl methacrylate, 2-hydroxyethyl methacrylate, methyl acrylate, ethyl acrylate, propyl acrylate, butyl acrylate, 2-ethylhexyl acrylate, dodecyl acrylate and the like; nitrogen-containing monomer such as (meth)acrylamide, (meth)acrylonitrile and the like; aromatic vinyl compounds such as styrene, vinyltoluene, divinylbenzene, p-tert-butylstyrene and the like; polyfunctional (meth)acrylates such as ethylene glycol di(meth)acrylate, diethylene glycol di(meth)acrylate, 1,4-butanediol di(meth)acrylate, 1,6-hexanediol di(meth)acrylate, trimethylolpropane tri(meth)acrylate, pentaerythritol triacrylate, pentaerythritol tetraacrylate and the like and they may be used solely or in combination of others. Among them, styrene is especially preferable.

The content of a reactive diluent is generally within 10 to 80 parts by weight in 100 parts by weight of the total of a flame retardant vinyl ester and the reactive diluent. Nevertheless, in order to obtain higher flame retardance, the content of the reactive diluent is preferable to be decreased and for the purpose, the content is further preferable within 10 to 60 parts by weight and furthermore preferable within 10 to 45 parts by weight.

The viscosity of the flame retardant vinyl ester resin of the present invention may properly be adjusted by the addition amount of a reactive deluent corresponding to the use purposes. In case of using the resin for a laminated plate, which is a preferable use purpose of the resin of the present invention, although it depends on the amounts of mixing agents and fillers to be added, the viscosity is generally 30 to 3,000 mPa•s, preferably 40 to 1,500mPa•s, at 25°C by measurement by a BH type viscometer in the stage where the reactive deluent is added to the flame retardant vinyl ester resin.

The flame retardant vinyl ester of the present invention may be used while being mixed with a conventionally well-known vinyl ester and unsaturated polyester as the resin having unsaturated bonds for the purpose of improving the physical properties and the productivity. The use amount of these compounds are properly determined according to the required properties and in terms of flame retardance, the amounts are preferably 5 to 200 parts by weight and more preferably 10 to 150 parts by weight to 100 parts by weight of flame retardant vinyl ester of the present invention.

The flame retardant vinyl ester resin containing a flame retardant vinyl ester of the present invention and a reactive diluent may be used as a flame retardant vinyl ester resin composition by adding a rubber component in order to provide toughness, impact resistance, punching processibility, interlayer adhesion strength. Examples usable as the rubber component to be added are liquid rubber such as carboxyl-terminated NBR, epoxy-terminated NBR, vinyl-terminated NBR and their modified materials and finely granular rubber such as cross-linked acrylic fine particles. The use amount of the rubber component is generally 1 to 30 parts by weight and preferably 2 to 20 parts by weight to 100 parts by weight of the total of the flame retardant vinyl ester and the reactive deluent,

For the purpose of providing further higher flame retardance, a halogen-free silicone type or nitrogen type flame retardant in an amount not to cause a bad effect on the physical properties can be added to the flame retardant vinyl ester resin of the present invention for molding materials such as a laminated plate.

The flame retardant vinyl ester resin of the present invention can easily be cured by adding a curing agent and if necessary, a curing accelerating agent to be commonly used at the time of curing an unsaturated polyester and a vinyl ester.

Examples of the curing agent to be used for the present invention are organic peroxides such as methyl ethyl ketone peroxide, tert-butyl peroxybenzoate, benzoyl peroxide, dicumyl peroxide, cumene hydroperoxide and the like. The amount of the curing agent to be used is preferably 0.1 to 5 parts by weight and more preferably 0.5 to 3 parts by weight in 100 parts by weight of the total of the flame retardant vinyl ester and the reactive diluent. Examples of the curing accelerating agent are cobalt naphthenate, cobalt octanate, manganese naphthanate, dimethylaniline, diethylaniline, acetylacetone and the like. The amount of the curing accelerating agent to be used is preferably 0.01 to 3 parts by weight to 100 parts by weight of the flame retardant vinyl ester resin.

A variety of cured products can be obtained from a flame retardant vinyl ester resin composition of the present invention by adding commonly used mixing agents such as a filler, a shrinkage-lowering agent or low profiling agent, a curing agent, a pigment, a dye, a polymerization inhibitor, a fiber-reinforcing material, an inner parting agent, a thickening agent and the like and then curing the resultant composition.

Examples of the filler are aluminum hydroxide, a glass powder, calcium carbonate, talc, silica, clay, a glass balloon and the like. They are generally used in amount of 400 or lower parts by weight in 100 parts by weight of the total of the flame retardant vinyl ester and the reactive deluent. Examples of the low profiling agent are saturated polyesters, poly(methyl methacrylate), poly(vinyl acetate), cross-linked polystyrene, styrene-butadiene (block) copolymer and its hydrogenated copolymer, vinyl acetate-styrene (block) copolymer, (meth)acrylic acid-styrene (block) copolymer and the like. These low profiling agents are generally used in amount of 30 or lower parts by weight in 100 parts by weight of the flame retardant vinyl ester resin. Examples of the inner parting agent are metal soap represented with calcium stearate and zinc stearate, silicon-or fluorine-containing organic compounds, phosphoric acid type compounds and the like and they are generally used in amount of 10 or lower parts by weight in 100 parts by weight of the flame retardant vinyl ester resin composition. Examples of the pigment are titanium oxide, carbon black, red iron oxide, phthalocyanine Blue and the like.
Examples of the thickening agent are oxides or hydroxides of magnesium, calcium and the like. Examples of the fiber-reinforcing material are generally glass fibers with the diameter of about 8 to 15 µ and the length of 25 mm or shorter. The fiber-reinforcing material is generally added in about 1 to 40 % to the total amount of the flame retardant vinyl ester resin composition.

A flame retardant vinyl ester of the present invention may be mixed with the foregoing reactive deluent and some or all mixing agents to obtain a flame retardant vinyl ester resin composition and then glass cloth or glass paper is immersed in the composition and cured to obtain a laminated plate.

Further, reinforcing fiber layers of glass mat, glass cloth or glass paper are immersed in the flame retardant vinyl ester resin composition of the present invention and if necessary a plurality of resultant impregnated layers are layered and a metal foil such as a copper foil is laminated thereon and then the flame retardant vinyl ester resin composition of the resultant layered body is cured by heating to obtain a metal foil-laminated layered plate in which the reinforcing fiber layers and metal foil are integrally cured.

Next, a resist ink composition using an acid-adducted flame retardant vinyl ester of the present invention will be described.

The resist ink composition contains an acid-adducted flame retardant vinyl ester, a diluent, a photopolymerization initiator, and a thermosetting component of a compound having 2 or more epoxy groups in one molecule.

In order to obtain a resist ink composition, the resin is required to be possible to be developed with an alkaline solution. For that, either before or after addition of a phosphorus compound having the formula (1) to unsaturated bonds further to hydroxy groups generated by vinyl esterification after the vinyl ester is synthesized, a polybasic acid anhydride is added to obtain an acid-adducted flame retardant vinyl ester.

Examples of the polybasic acid anhydride are dibasic acid anhydrides such as maleic anhydride, succinic anhydride, itaconic anhydride, phthalic anhydride, tetrahydrophthalic anhydride, hexahydrophthalic anhydride, and the like and polybasic acid anhydrides such as trimellitic acid anhydride, pyromellitic acid anhydride, benzophenonetetracarboxylic acid anhydride, 5-(tetrahydro-2,5-dioxo-3-furanyl)-3-methyl-3-cyclohexene-1,2-dicarboxyli c acid anhydride and the like. They may be used solely or as a mixture of t2 or more of them.

In case of adding a phosphorus compound having the formula (1) to the unsaturated bonds of the vinyl ester, the addition reaction of a polybasic acid anhydride may be carried out either before or after the addition reaction of the phosphorus compound and preferably be carried out after the addition reaction.

The addition amount of the polybasic acid anhydride is determined depending on the developable property and the moisture-proofness required as a resist ink, it is generally preferable to set the addition amount as to keep the acid value of the vinyl ester within a range of 45 to 160 mgKOH/g.

A diluent is used for the purpose of adjusting the viscosity and/or improving the reactivity of the acid-adducted flame retardant vinyl ester obtained by the foregoing method. As the diluent to be used at the time of synthesizing the acid-adducted flame retardant vinyl ester or at the time of using it, any inactive diluent, that is a diluent inactive on epoxy groups and carboxyl groups, can be used among well-known organic solvents without any specific restriction. Examples of the inactive diluent are ethylene glycol monoalkyl ether acetates such as ethyl acetate, isopropyl acetate, cellosolve acetate, butylcellosolve acetate and the like; diethylene glycol monoalkyl ether acetates such as diethylene glycol monomethyl ether acetate, carbitol acetate, butylcarbitol acetate and the like; propylene glycol monoalkyl ether acetates; acetic acid esters such as dipropylene glycol monoalkyl ether acetates; ethylene glycol dialkyl ethers; diethylene glycol dialkyl ethers such as methyl carbitol, ethyl carbitol, butyl carbitol and the like; triethylene glycol dialkyl ethers; propylene glycol dialkyl ethers; dipropylene glycol dialkyl ethers; ethers such as 1,4-dioxane, tetrahydrofuran and the like; ketones such as acetone, methyl ethyl ketone, methyl isobutyl ketone, cyclohexanone, butyrolactone and the like; hydrocarbons such as benzene, toluene, xylene, tetramethylbenzene, tetralin, octane, decane and the like; petroleum type solvents such as petroleum ether, petroleum naphtha, hydrogenated petroleum naphtha, solvent naphtha and the like; and a diluent such as dimethyl formamide and N-methylpyrrolidone.

In addition to the inactive diluent, the following reactive diluents may be used together: methyl (meth)acrylate, ethyl (meth)acrylate, n-butyl (meth)acrylate, isobutyl (meth)acrylate, 2-ethylhexyl (meth)acrylate, isodecyl (meth)acrylate, n-lauryl (meth)acrylate, tridecyl (meth)acrylate, n-stearyl (meth)acrylate, methoxypolyethylene glycol (meth)acrylate, cyclohexyl (meth)acrylate, tetrahydrofurfuryl (meth)acrylate, isobornyl (meth)acrylate, benzyl (meth)acrylate, 2-hydroxyethyl (meth)acrylate, 2-hydroxypropyl (meth)acrylate, 2-hydroxybutyl (meth)acrylate, dimethylaminoethyl (meth)acrylate, diethylaminoethyl (meth)acrylate, ethylene glycol di(meth)acrylate, diethylene glycol di(meth)acrylate, 1,4-butanediol di(meth)acrylate, 1,6-hexanediol di(meth)acrylate, trimethylolpropane tri(meth)acrylate, glycerin di(meth)acrylate, pentaerythritol tri(meth)acrylate, pentaerythritol tetra(meth)acrylate, dipentaerythritol hexa(meth)acrylate, pentaerythritol diacrylate monostearate (Aronix M-233, produced by Toagosei Chemical Industry Co., Ltd.), fatty acid-modified dipentaerythritol polyacrylate (Aronix M-430, produced by Toagosei Chemical Industry Co., Ltd.), a reaction product of polyester acrylate and a dibasic acid anhydride and an alcohol having at least one unsaturated bond in one molecule and the like. The content of these reactive diluents is generally 5 to 80 parts by weight, preferably 10 to 60 parts by weight, in 100 parts by weight of the total of the acid-adducted flame retardant vinyl ester, diluents, a photopolymerization initiator and a thermosetting component.

As a diluent inactive to the reaction and to be used only at the time of using the acid-adducted flame retardant vinyl ester, the following examples of alcohol type diluents may be used: methanol, ethanol, propanol, cyclohexanol; ethylene glycol monoalkyl ethers such as ethylene glycol, propylene glycol, methylcellosolve, ethylcellosolve, butylcellosolve and the like; diethylene glycol monoalkyl ethers such as diethyl glycol monomethyl ether, diethylene glycol monoethyl ether and the like; triethylene glycol monoalkyl ethers such as triethylene glycol monomethyl ether; propylene glycol monoalkyl ethers such as propylene glycol monomethyl ether; dipropylene glycol monoalkyl ether acetates such as diethylene glycol monoethyl ethers and the like.

These diluents may be used solely or as a mixture of two or more of them. The amount of the diluents to be used in a composition of the present invention is 30 to 300 parts by weight and preferably 50 to 200 parts by weight to 100 parts by weight of the acid-adducted flame retardant vinyl ester.

Examples of the photopolymerization initiator are acetophenone type, benzoin type, benzophenone type, thioxane type, phosphorus type and the like.

Examples of the acetophenone type are diethoxyacetophenone, 2-hydroxy-2-methyl-1-phenylpropane-1-one, benzyldimethylketal (Irgacure 651, produced by Ciba-Geigy Corp.), 2-methyl-2-morpholino-(4-thiomethylphenyl)propane-1-one (Irgacure 907, produced by Ciba-Geigy Corp.), 2-benzyl-2-dimethylamino-1-(4-morpholinophenyl)-butanone (Irgacure 369, produced by Ciba-Geigy Corp.) and the like.

Examples of the benzoin type are benzoin, benzoin methyl ether, benzoin ethyl ether and the like.

Examples of the benzophenone type are benzophenone, hydroxybenzophenone, 4-phenylbenzophenone, 3,3',4,4'-tetra(tert-butylperoxycarbonyl)benzophenone (BTTB, produced by Nippon Oil and Fats Co., Ltd.)

Examples of the thioxane type are 2-isopropylthioxanthone, 2,4-dimethylthioxanthone, 2,4-diethylthioxanthone (Kayacure DETX, produced by Nippon Kayaku Co., Ltd.) and the like. Examples of the phosphorus type are acylphosphine oxide (Lucitin TPO, produced by BASF Co., Ltd.) and the like.

The photo-polymerization initiator may be used solely or as a mixture of two or more of them. The amount of the photopolymerization initiator contained in the resist ink composition of the present invention is preferably 0.1 to 30 parts by weight and particularly preferably 1 to 20 parts by weight to 100 parts by weight of the acid-adducted flame retardant vinyl ester. If the addition amount is less than 0.1 parts by weight, sufficient curing cannot be carried out and necessary physical properties cannot be obtained. On the other hand, if the amount exceeds 30 parts by weight, the cost for the materials increases and thus it is not preferable.

As the epoxy compound as a themosetting component having 2 or more epoxy groups in one molecule, examples are bisphenol type epoxy resin represented by bisphenol A type and bisphenol F type as described in Japanese Patent Laid-Open No. Hei 9 - 110948; novolak type epoxy resin represented by phenol novolak and cresol novolak; aliphatic type epoxy resin; nitrogen-containing epoxy resin; and copolymer type epoxy resin. It is preferable to add a slight amount of a curing accelerating agent for the epoxy groups of the epoxy compounds to the resist ink composition of the present invention to improve the thermosetting property and practical examples are amines such as dicyandiamide, imidazoles, carboxylic acids, and quaternary ammonium salts.

The amount of the thermosetting component to be used is 10 to 150 parts by weight and preferably 30 to 50 parts by weight to 100 parts by weight of the acid-adducted flame retardant vinyl ester. The curing accelerating agent of the thermosetting component may be used to 1 to 20 parts by weight in 100 parts by weight of the thermosetting component.

Further, the resist ink composition of the present invention may contain a polymerization inhibitor, a filler, a defoaming agent, a coloring agent, a leveling agent and the like. Examples of the polymerization inhibitor are hydroquinone, p-toluquinone, phenothiazine, diketones and the like.

Examples of the filling agent are talc, for example, Micro Ace K-1, (produced by Shiraishi Calcium Kaisha, Ltd.), barium sulfate, silica, for example, Imsil A-108 (produced by Tatsumori Ltd.), Aerosil 200 (Nippon Aerosil Co., Ltd.) and the like. Examples of the defoaming agent are silicone oil such as KF-69 (produced by Sin-Etsu Silicone Co., Ltd.) and the like. Examples of the coloring agent are phthalocyanine Blue, phthalocyanine Green, leuco dyes, carbon black, titanium oxide and the like.

The resist ink composition of the present invention may further contain a halogen-free phosphorus type, silicone type, or nitrogen type flame retardant in a proper amount with which no bad effect on the physical properties is caused for the purpose of providing further improved flame retardance.

The resist ink composition of the present invention can be obtained by evenly stirring and kneading the respective components by a disper, a roll mill, a resolver and the like.

In case of using resist ink composition of the present invention as a solder-resist resin composition, a cured product can be obtained by, for example, following method. That is, a polymerizable composition of the present invention is applied in 10 to 200 µm film thickness to a printed circuit board by a screen printing method, a spraying method, a curtain coater method, a roll coater method, a dip coating method, a doctor knife method, an electrostatic coating method, and the like and the obtained coating film is dried at 60 to 110°C to remove organic solvents. After the drying, a negative film is directly brought into contact with the coating film and ultraviolet rays are radiated (exposure is carried out) using a high pressure mercury lamp, a metal halide lamp and the like and then un-exposed parts are washed out (development is carried out) with an aqueous alkaline diluted solution with 1 to 2% concentration and after that, sufficient curing is carried out by radiating ultraviolet rays and/or heating (for example, at 100 to 200°C for 30 to 60 minutes) in order to further improve the physical properties and thus a cured coating film is obtained.

Incidentally, throughout this specification, % is on the basis of weight unless a proviso is provided and the unit of the equivalent is g/mol.

### BEST EMBODIMENTS OF THE INVENTION

### Examples

Although the present invention will be described more particularly according to examples and comparative examples, the present invention is not at all restricted to those examples.

### Example 1 (Production of resin for a laminated plate)

To a flask having 4 necks and 3 liter capacity, equipped with a reflux condenser and a stirring apparatus, 1084.7 g of bisphenol A type epoxy resin (YD 128, produced by Tohto Kasei Co., Ltd., epoxy equivalent 187), 448.4 g of HCAHQ (OH group/epoxy group = 0.48), and 0.45 g of triphenylphosphine were added and reaction was carried out at 160°C for 3 hours to obtain a phosphorus-containing epoxy resin with epoxy equivalent of 500. Further, 264.2 g of methacrylic acid and 5.4 g of triphenylphosphine were added to the obtained resin and reaction was carried out at 130°C for 2 hours until the reaction ratio of the epoxy groups exceeded 99% and to obtain resin having phosphorus content of 2.35% and double bond equivalent 586 g/mol. The obtained resin was dissolved in 1200 g of styrene monomer to obtain resin (1) for a laminated plate with 1.4% of phosphorus content and 60% of nonvolatile components.

### Example 2 (Production of resin for a laminated plate)

To a flask having 4 necks, 3 liter capacity and equipped with a reflux condenser and a stirring apparatus, 963.6 g of bisphenol A type epoxy resin (YD 128, produced by Tohto Kasei Co., Ltd., epoxy equivalent 187), 397.4 g of HCAHQ (OH group/epoxy group = 0.48), and 0.40 g of triphenylphosphine were added and reaction was carried out at 160°C for 3 hours to obtain a phosphorus-containing epoxy resin with epoxy equivalent of 500. Further, 117.0 g of methacrylic acid and 322.0 g of hydroxyethyl methacrylate-maleic anhydride (1 : 1) adduct, and 5.4 g of triphenylphosphine were added to the obtained resin and reaction was carried out at 130°C for 2 hours until the reaction ratio of the epoxy groups exceeded 99% and to obtain resin having phosphorus content of 2.09% and double bond equivalent 430 g/mol. The obtained resin was dissolved in 1200 g of styrene monomer to obtain resin (2) for a laminated plate with 1.3% of phosphorus content and 60% of nonvolatile components.

### Example 3 (Production of resin for a laminated plate)

In a flask having 4 necks and 1 liter capacity and equipped with a reflux condenser and a stirring apparatus, 172 g of methacrylic acid was added to 374 g of bisphenol A type epoxy resin (YD 128, produced by Tohto Kasei Co., Ltd., epoxy equivalent 187) in the presence of 0.3 g of hydroquinone and 0.3 g of benzyldimethylamine and reaction was carried out at 120°C until the epoxy reaction ratio exceeded 99% (unsaturated double bond equivalent 273 g/mol). After that, 364 g of styrene monomer was added to obtain resin (3) for a laminated plate containing no phosphorus and 60% of nonvolatile components.

### Example 4 (Production of resin for a laminated plate)

A flask having 4 necks, 1 liter capacity and equipped with a stirring apparatus was loaded with 180.0 g of a phenol novolak type epoxy resin (YDPN 638, produced by Tohto Kasei Co., Ltd., epoxy equivalent 180) and 51.8 g of HCA (P-H group/epoxy group = 0.23) and reaction was carried out at 180°C for 5 hours to reach epoxy equivalent 305 and the reaction was thus completed. Next, 65.4 g of methacrylic acid, 0.45 g of hydroquinone, a polymerization inhibitor, and 2.38 g of triphenylphosphine were supplied and reaction was carried out at 120°C for 12 hours to reach the acid value 0 mgKOH/g (unsaturated bond equivalent 391 g/mol). After that, the obtained resin was dissolved in 198 g of styrene monomer to obtain resin (4) for a laminated plate with 1.5% of phosphorus content and 60% of nonvolatile components.

### Example 5 (Production of resin for a laminated plate)

A flask having 4 necks, 1 liter capacity and equipped with a stirring apparatus was loaded with 200.0 g of a cresol novolak type epoxy resin (YDCN 701P, produced by Tohto Kasei Co., Ltd., epoxy equivalent 200) and 55.7 g of HCA (P-H group/epoxy group = 0.26) and reaction was carried out at 180°C for 3 hours to reach epoxy equivalent 346 and the reaction was thus completed. Next, 63.6 g of methacrylic acid, 0.48 g of hydroquinone, a polymerization inhibitor, and 2.55 g of triphenylphosphine were supplied and reaction was carried out at 120°C for 12 hours to reach the acid value 0 mgKOH/g (unsaturated bond equivalent 431.5 g/mol). After that, the obtained resin was dissolved in 213 g of styrene monomer to obtain resin (5) for a laminated plate with 1.5% of phosphorus content and 60% of nonvolatile components.

### Example 6 (Production of resin for a laminated plate)

In a flask having 4 necks and 3 liter capacity and equipped with a reflux condenser and a stirring apparatus, 1010 g of a cresol novolak type epoxy resin (YDCN 701P, produced by Tohto Kasei Co., Ltd., epoxy equivalent 202), and 360 g of acrylic acid were reacted in the presence of 4.1 g triphenylphosphine at 110°C for 8 hours to obtain vinyl ester resin with the acid value of 1.0 mgKOH/g. The obtained resin was then mixed with 270 g of HCA (P-H group/double bond = 0.25) and reaction was carried out at 130°C for 2 hours to complete the reaction of entire HCA (phosphorus content 2.36% and unsaturated bond equivalent 437.3 g/mol), that was confirmed by NMR. After that, the obtained resin was dissolved in 1095 g of styrene monomer to obtain resin (6) for a laminated plate with 1.4% of phosphorus content and 60% of nonvolatile components.

### Example 7 (Production of resin for a laminated plate)

In a flask having 4 necks, and 3 liter capacity and equipped with a reflux condenser and a stirring apparatus, 1062 g of a phenol novolak type epoxy resin (YDPN 638, produced by Tohto Kasei Co., Ltd., epoxy equivalent 177), and 516 g of acrylic acid were reacted in the presence of 4.8 g triphenylphosphine at 130°C for 6 hours to obtain vinyl ester resin with the acid value of 1.2 mgKOH/g. The obtained resin was then mixed with 324 g of HCA (P-H group/double bond = 0.25) and reaction was carried out at 130°C for 2 hours to complete the reaction of entire HCA (phosphorus content 2.44% and unsaturated bond equivalent 422.7 g/mol), that was confirmed by NMR. After that, the obtained resin was dissolved in 1050 g of styrene monomer to obtain resin (7) for a laminated plate with 1.6% of phosphorus content and 65% of nonvolatile components.

### Example 8 (Production of resin for a laminated plate)

In a flask having 4 necks, 3 liter capacity and equipped with a reflux condenser and a stirring apparatus, 796.5 g of a phenol novolak type epoxy resin (YDPN 638, produced by Tohto Kasei Co., Ltd., epoxy equivalent 177), 258 g of methacrylic acid, and 342 g of maleic anhydride-2-hydroxyethyl methacrylate (1 : 1) reaction product were reacted in the presence of 4.2 g triphenylphosphine at 130°C for 6 hours to obtain vinyl ester resin with the acid value of 1.2 mgKOH/g. The obtained resin was then mixed with 243 g of HCA (P-H group/double bond = 0.19) and reaction was carried out at 130°C for 2 hours to complete the reaction of entire HCA (phosphorus content 2.13% and unsaturated bond equivalent 364.3 g/mol), that was confirmed by NMR. After that, the obtained resin was dissolved in 729 g of styrene monomer to obtain resin (8) for a laminated plate with 1.5% of phosphorus content and 70% of nonvolatile components.

### Comparative Example 1 (Production of resin for a laminated plate)

In a flask having 4 necks and 1 liter capacity and equipped with a reflux condenser and a stirring apparatus, 301 g of methacrylic acid was added to 1400 g of bromine-containing epoxy resin (YDB 400, produced by Tohto Kasei Co., Ltd., epoxy equivalent 400) in the presence of 0.3 g of hydroquinone and 0.3 g of benzyldimethylamine and reaction was carried out at 120°C until the epoxy reaction ratio exceeded 99% (unsaturated double bond equivalent 486 g/mol). After that, 1134 g of styrene monomer was added to obtain resin (9) for a laminated plate containing no phosphorus and 60% of nonvolatile components.

### Comparative Example 2 (Production of resin for laminated plate)

A flask having 4 necks, 1 liter capacity and equipped with a stirring apparatus was loaded with 200.0 g of cresol novolak type epoxy resin (YDCN 702P, produced by Tohto Kasei Co., Ltd., epoxy equivalent 200), 86 g of methacrylic acid, and 0.43 g of hydroquinone. Then, 2.29 g of triphenylphosphine was supplied and reaction was carried out at 120°C for 12 hours to find the acid value 0 mgKOH/g (unsaturated double bond equivalent 286 g/mol). The obtained resin was dissolved in 191 g of styrene monomer to obtain resin (10) for a laminated plate containing no phosphorus and 60% of nonvolatile components.

### Example 9 (Production of an injection molded plate)

The resin (1) for a laminated plate in 70 parts by weight and the resin (3) for a laminated plate in 30 parts by weight were mixed and further mixed with 1 parts by weight of cumene hydroperoxide (Percumyl H-80, produced by Nippon Oil and Fats Co., Ltd.) with 80% grade as a curing agent and the resultant mixture was stirred and injected in a molding die. The resultant resin was heated at 100°C for 60 minutes and then at 175°C for 30 minutes to cure the resin and to produce a 3 mm-thick injection molded plate.

### Comparative Example 3 (Production of an injection molded plate)

A 3 mm-thick injection molded plate was produced by the same method as that of Example 9 using the resin (9) for a laminated plate.

### Test Example 1

Regarding the injection molded plate obtained by Example 9 and the injection molded plate obtained by Comparative Example 3, bending physical properties were measured and the glass transition temperature (Tg) was calculated from the peak of tan δ of the viscoelasticity based on JIS K 7203.

The results are shown in Table 1

**Table 1**

| | | Example 9 | Comparative Example 3 |
|---|---|---|---|
| Resin mixing ratio (parts by weight) | Resin (1) for a laminated plate | 70 | |
| | Resin (3) for a laminated plate | 30 | |
| | Resin (9) for a laminated plate | | 100 |
| | Curing agent^{*1} | 1.25 | 1.25 |
| Mechanophysical properties | Flexural strength (MPa) | 150 | 149 |
| | Flexural modulus (GPa) | 3.55 | 3.71 |
| | Deflection in bending(%) | 6.89 | 6.53 |
| | Tg(°C) | 155 | 160 |

| | | | |
|---|---|---|---|
| *1: Percumyl H-80 (produced by Nippon Oil and Fats Co., Ltd.) cumene hydroperoxide with 80% grade | | | |

According to the results in Table 1, mechanophysical properties of the injection molded plate of Example 9 of the present invention were found by no means inferior to those of the injection molded plate of Comparative Example 3 using conventionally employed bromine-containing resin although the injection molded plate of Example 9 was free from halogen.

### Examples 10 to 16 (Preparation of resin compositions for molding laminated plates and production of injection molded plates)

Resin compositions for molding respective laminated plates were prepared by mixing resin for respective laminated plates and mixing agents in the mixing ratios as shown in Table 2. The obtained respective resin compositions for molding were injected into molding dies and heated at 100°C for 60 minutes and then at 175°C for 30 minutes to cure the compositions and to produce 1 mm-thick injection molded plates.

The mixing agents used were as follows.
Cross-linked acrylic rubber fine particle: Staphyloid AC-3355 (produced by Takeda Chemical Industries, Ltd.)
Phosphorus type flame retardant: PX-200 (produced by Daihachi Chemical Industry Co., Ltd.)
Aluminum hydroxide: CL-320 (produced by Sumitomo Chemical Co., Ltd.)
Curing agent: cumene hydroperoxide with 80% grade, Percumyl H-80 (produced by Nippon Oil and Fats Co., Ltd.)
Comparative Examples 4 and 5 (Preparation of resin compositions for molding laminated plates and production of injection molded plates)

Resin compositions for molding were prepared by using mixing agents in the mixing ratios as shown in Table 2 and 1 mm-thick injection molded plates were produced in the same manner as Examples 10 to 16.

### Test Example 2

Regarding injection molded plates produced by Examples 10 to 16 and Comparative Examples 4 and 5, tests for the flame retardance and the heat resistance were carried out by following methods.
Flame retardance: based on UL-94
Heat resistance: the time (second) until blistering took place in case of immersing the injection molded plates in a solder bath at 260°C was measured.
Heat resistance after PCT: the forgoing heat resistance was measured after PCT was carried out at 121°C for 1 hour under 95% humidity.

The test results were shown together with mixture compositions of each resin in Table 2.

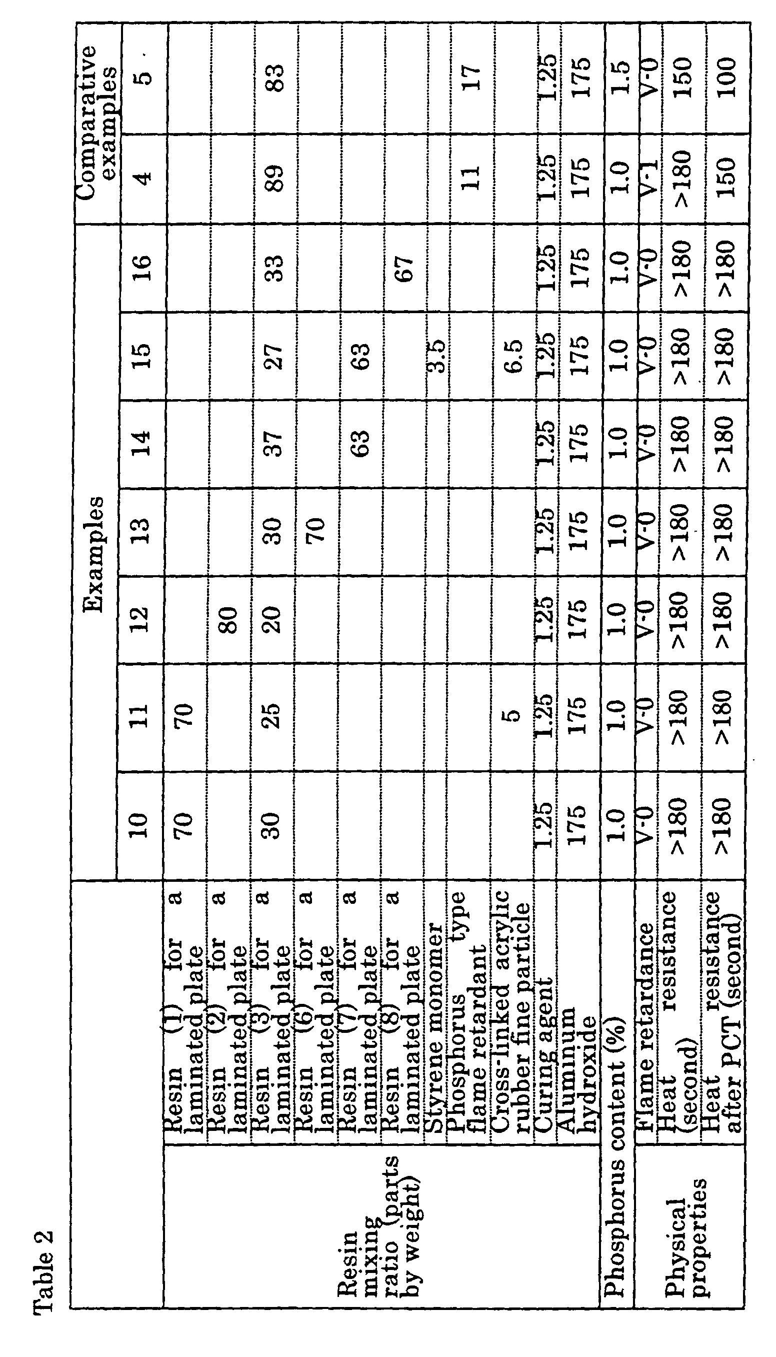

### Examples 17 and 18 (Preparation of resin compositions for molding and production of injection molded plates)

Resin compositions for molding were prepared by mixing resin (4), (5) for respective laminated plates and mixing agents as shown in Table 3 and 1 mm-thick laminated plates were produced by the same method as Examples 10 to 16.

### Comparative example 6 (Preparation of resin composition for molding and production of an injection molded plate)

A resin composition for molding was prepared by mixing resin (10), for a laminated plate and respective mixing agents as shown in Table 3 and a 1 mm-thick laminated plate was produced by the same method as Examples 10 to 16.

### Test Example 3

Regarding injection-molded plates produced by Examples 17 and 18 and comparative examples 6, tests were carried out in the same manner as Test Examples 1 and 2. The results were shown together with the resin mixture compositions in Table 3

**Table 3**

| | | Example 17 | Example 18 | Comparative Example 6 |
|---|---|---|---|---|
| Resin mixing ratio (parts by weight) | Resin (4) for a laminated plate | 100 | | |
| | Resin (5) for a laminated plate | | 100 | |
| | Resin (10) for a laminated plate | | | 83 |
| | A phosphorus type flame retardant^{*1} | | | 17 |
| | A curing agent^{*2} | 1.25 | 1.25 | 1.25 |
| | Aluminum hydroxide^{*3} | 150 | 150 | 150 |
| Phosphorus content in resin (%) | | 1.5 | 1.5 | 1.5 |
| Physical properties | Tg(°C) | 175.0 | 170.0 | 140.0 |
| | Flame retardance | V-0 | V-0 | V-1 |
| | Heat resistance (second) | >180 | >180 | 140 |
| | Heat resistance after PCT (second) | >180 | >180 | 170 |

| | | | | |
|---|---|---|---|---|
| *1: PX200 (produced by Daihachi Chemical Industry Co., Ltd.) | | | | |
| *2: CL-320 (produced by Sumitomo Chemical Co., Ltd.) | | | | |
| *3: Percumyl H-80 (produced by Nippon Oil and Fats Co., Ltd.) cumene hydroperoxide with 80% grade. | | | | |

According to Table 2 and Table 3, the injection-molded plates of Examples 10 to 18 were all found having high flame retardance, heat resistance and moisture-proofness. Also, according to the injection-molded plate of Comparative Example 6, in case of using a phosphorus type flame retardant to make the plate flame retardant, heat resistance, especially the heat resistance after PCT, was low and moreover it was found that higher phosphorus content was required to obtain flame retardance as same as that of resin of the present invention.

### Example 19 (Production of photosensitive resin)

A flask having 4 necks and 1 liter capacity and equipped with a stirring apparatus was loaded with 180.0 g of a phenol novolak type epoxy resin (YDPN 638, produced by Tohto Kasei Co., Ltd., epoxy equivalent 180), 120 g of bisphenol F type epoxy resin (YDF 170, produced by Tohto Kasei Co., Ltd., epoxy equivalent 170), 33.4 g of HCA (P-H group/epoxy group = 0.09), 50.1 g of HCAHQ (OH group/epoxy group = 0.18) and then reaction was carried out at 180°C for 3 hours in the presence of 0.025 g of tetrabutylphosphonium acetate as a catalyst to reach epoxy equivalent 305 and the reaction was thus finished.

Next, 269.0 g of carbitol acetate, 0.75 g of hydroquinone, and 72.0 g of acrylic acid were further supplied and in the presence of 5.0 g of triphenylphosphine as a catalyst, reaction was carried out at 130°C for 10 hours to reach the acid value 0 mgKOH/g. After that, 124.6 g of tetrahydrophthalic acid anhydride was supplied and reaction was carried out at the same temperature for 5 hours and it was confirmed by infrared absorption spectrum that the acid anhydride was completely reacted (unsaturated bond equivalent 580 g/mol). In such a manner, obtained was photosensitive resin (1) having 92 mgKOH/g acid value of nonvolatile components and 1.5% of phosphorus content and containing 65% of nonvolatile components.

### Example 20 (Production of photosensitive resin)

A flask having 4 necks and 1 liter capacity and equipped with a stirring apparatus was loaded with 200.0 g of a cresol novolak type epoxy resin (YDCN 702P, produced by Tohto Kasei Co., Ltd., epoxy equivalent 200), 41.0 g of HCA (P-H group/epoxy group = 0.19) and 211.1 g of carbitol acetate and then reaction was carried out at 180°C for 3 hours to reach epoxy equivalent 559 and the reaction was thus finished. Then, 58.3 g of an acid, 0.45 g of hydroquinone as a polymerization inhibitor, and 2.39 g of triphenylphosphine were supplied and reaction was carried out at 120°C for 10 hours to reach the acid value 0 mgKOH/g. After that, 92.7 g of tetrahydrophthalic acid anhydride was supplied and reaction was carried out at the same temperature for 5 hours and it was confirmed by infrared absorption spectrum that the acid anhydride was completely reacted (unsaturated bond equivalent 484 g/mol). In such a manner, obtained was photosensitive resin (2) having 89 mgKOH/g acid value of nonvolatile components and 1.5% of phosphorus content and containing 65% of nonvolatile components.

### Example 21 (Production of photosensitive resin)

A flask having 4 necks and 1 liter capacity and equipped with a stirring apparatus was loaded with 180.0 g of a phenol novolak type epoxy resin (YDPN 638, produced by Tohto Kasei Co., Ltd., epoxy equivalent 180), 38.4 g of HCA (P-H group/epoxy group = 0.18) and 197.7 g of carbitol acetate and then reaction was carried out at 180°C for 5 hours to reach epoxy equivalent 506 and the reaction was thus finished.

Next, 59.2 g of acrylic acid, 0.41 g of hydroquinone as a polymerization inhibitor, and 2.22 g of triphenylphosphine were supplied and reaction was carried out at 120°C for 12 hours to reach the acid value 0 mgKOH/g. After that, 89.5 g of tetrahydrophthalic acid anhydride was supplied and reaction was carried out at the same temperature for 5 hours and it was confirmed by infrared absorption spectrum that the acid anhydride was completely reacted (unsaturated bond equivalent 448 g/mol). In such a manner, obtained was photosensitive resin (3) having 90 mgKOH/g acid value of nonvolatile components and 1.5% of phosphorus content and containing 65% of nonvolatile components.

### Example 22 (Production of photosensitive resin)

A flask having 4 necks and 1 liter capacity and equipped with a stirring apparatus was loaded with 200.0 g of a cresol novolak type epoxy resin (YDCN 702P, produced by Tohto Kasei Co., Ltd., epoxy equivalent 200), 72 g of acrylic acid, 222.9 g of carbitol acetate, 0.41 g of hydroquinone as a polymerization inhibitor, and 2.18 g of triphenylphosphine as a catalyst and then reaction was carried out at 110°C for 8 hours to obtain vinyl ester resin with acid value of 1.2 mgKOH/g. Then, 41.0 g of HCA (P-H group/double bond = 0.19) was supplied and reacted at 130°C for 6 hours and that the completion of reaction of HCA was confirmed by NMR. After that, 101.8 g of tetrahydrophthalic anhydride was supplied and reaction was carried out at 110°C for 5 hours and it was confirmed by infrared absorption spectrum that the acid anhydride was completely reacted. In such a manner, obtained was photosensitive resin (4) having 91 mgKOH/g acid value of nonvolatile components, 1.5% of phosphorus content, and 418 g/mol unsaturated bond equivalent g/mol and containing 65% of nonvolatile components.

### Example 23 (Production of photosensitive resin)

Photosensitive resin (5) having 91 mgKOH/g acid value of nonvolatile components, 2.0% of phosphorus content, and 447 g/mol unsaturated bond equivalent and 65% of nonvolatile components was obtained in the same manner as Example 22 except that the amounts of carbitol acetate, HCA (P-H group/double bond = 0.29), and tetrahydrophthalic acid anhydride were changed to 239.1 g, 62.6 g, and 109.4 g, respectively.

### Comparative Example 7 (Production of photosensitive resin)

A flask having 4 necks and 1 liter capacity and equipped with a stirring apparatus was loaded with 200.0 g of a cresol novolak type epoxy resin (YDCN 702P, produced by Tohto Kasei Co., Ltd., epoxy equivalent 200), 72 g of acrylic acid, 195.6 g of carbitol acetate, and 0.41 g of hydroquinone as a polymerization inhibitor. Then, 2.18 g of triphenylphosphine was supplied and reaction was carried out at 120°C for 15 hours to reach the acid value 0 mgKOH/g. After that, 91.2 g of tetrahydrophthalic acid anhydride was supplied and reaction was carried out at the same temperature for 2 hours and it was confirmed by infrared absorption spectrum that the acid anhydride was completely reacted. In such a manner, obtained was photosensitive resin (6) having 93 mgKOH/g acid value of nonvolatile components and 364 g/mol unsaturated bond equivalent and containing 65% of nonvolatile components but no phosphorus.

### Example 24 (Preparation of a resist ink composition)

Using the photosensitive resin (1) obtained in Example 19, the main components and the curing agent for a resist ink composition were prepared by the following description.

| Main Components | |
|---|---|
| Photosensitive resin (1) | 154 parts by weight |
| Carbitol acetate | 18 parts by weight |
| Ipsol 150 | 5 parts by weight |
| Aronix M-233 | 22 parts by weight |
| Irgacure 907 | 15 parts by weight |
| Dicyandiamide | 1.0 parts by weight |
| Imsil A-108 | 60 parts by weight |
| Aerosil 200 | 8 parts by weight |
| Barium sulfate | 30 parts by weight |
| Phthalocyanine Green | 1.4 parts by weight |
| KF-69 | 2.0 parts by weight |
| Micro Ace K-1 | 110 parts by weight |
| Total | 426.5 parts by weight |

| Curing agent | |
|---|---|
| YDPN 638 | 20 parts by weight |
| Triglycidyl isocyanurate | 20 parts by weight |
| Talc | 10 parts by weight |
| Barium sulfate | 30 parts by weight |
| Carbitol acetate | 10 parts by weight |
| Ipsol 150 | 5 parts by weight |
| Total | 95 parts by weight |

The foregoing main components and curing agent were separately kneaded and then mixed with each other to obtain a resist ink composition (1)

### Example 25 (Preparation of a resist ink composition)

A resist ink composition (2) was prepared in the same manner as Example 24 except that the photosensitive resin (2) was used in place of the photosensitive resin (1) in Example 24.

### Example 26 (Preparation of a resist ink composition)

A resist ink composition (3) was prepared in the same manner as Example 24 except that the photosensitive resin (3) was used in place of the photosensitive resin (1) in Example 24.

### Comparative Example 8 (Preparation of a resist ink composition)

A resist ink composition (4) was prepared in the same manner as Example 24 except that 129 parts by weight of the photosensitive resin (6) was used in place of the photosensitive resin (1) in Example 24 and that 16 parts by weight of a phosphorus type flame retardant (PX 200, produced by Daihachi Chemical Industry Co., Ltd.) and 8.6 parts by weight of carbitol acetate were additionally added to the curing agent.

### Comparative Example 9 (Preparation of a resist ink composition)

A resist ink composition (5) was prepared in the same manner as Example 24 except that the photosensitive resin (6) was used in place of the photosensitive resin (1) in Example 24.

### Example 27 (Preparation of a resist ink composition)

A resist ink composition (6) was prepared by mixing 75 parts by weight of resist ink composition (2) and 25 parts by weight of resist ink composition (3).

### Example 28 (Preparation of a resist ink composition)

A resist ink composition (7) was prepared in the same manner as Example 24 except that the photosensitive resin (4) was used in place of the photosensitive resin (1) in Example 24.

### Example 29 (Preparation of a resist ink composition)

A resist ink composition (8) was prepared in the same manner as Example 24 except that the photosensitive resin (5) was used in place of the photosensitive resin (1) in Example 24.

### Test Example 3

The resist ink compositions (1) to (5) were respectively applied to the entire surface of 1.6 mm-thick and halogen-free type printed substrates in 20 µm thickness by a screen printing method using 180 mesh polyester screens and the formed films were heated at 85°C for 40 minutes to remove the solvent. Then, ultraviolet rays were radiated in 35 mJ/cm² exposure intensity through negative masks and development was carried out by spraying an aqueous 1% sodium carbonate solution at 30°C for 40 seconds and 2.0 kg/cm² spray pressure to dissolve un-exposed parts. At that time, the development properties of the un-exposed parts were evaluated as follows.

### Development properties

Investigated was the relation of development properties of the resist coatings with the lapse of drying time in the case where resist ink compositions were applied in 20 µm to the entire surface of halogen-free printed substrates and dried at 85°C. That is, the resist coatings were exposed through a pattern at every specified drying time and developed with an aqueous sodium carbonate solution in the above-described manner. In such a way, the time until the un-exposed parts could not be dissolved and the development became impossible was measured. As the time was longer, the time margin till the exposure after resist application was wide to make the process control easy and improve the workability and the reliability as well.

Simultaneously, a sensitivity test was also carried out using step tablets produced by Fuji Photo Film Co., Ltd. and evaluation was carried out according to the number of the steps, 1 to 15 steps. The results are shown in Table 4.

### Heat resistance

After development, cured films were obtained by heating the film at 150°C for 40 hours by a hot air blowing drier. The cured films were subjected to an adhesion strength test by a tessellation test and solder heat resistance test by a solder flow test at 260°C for 10 seconds and all were found having no problem and satisfactorily excellent properties.

Further, using the obtained substrates, a flame retardance test (bases on UL 94) and PCT (at 121°C and RH 95% for 1 hour) were carried out. The obtained results are shown in Table 4.

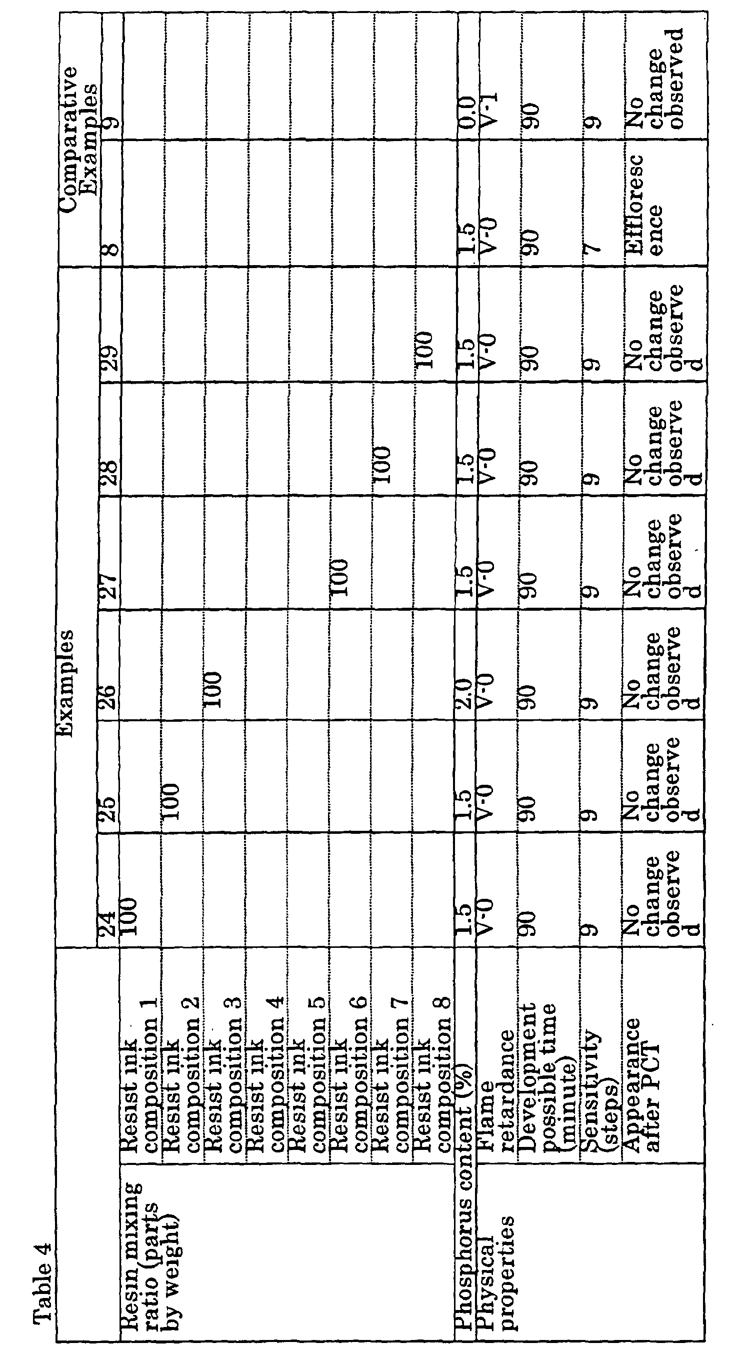

Any of the compositions of the present invention was found satisfying all of the required physical properties and in contrast with that, the resist ink composition of Comparative Example 8 containing phosphorus-free photosensitive resin (6) and a phosphorus type flame retardant added to the resin was inferior in sensitivity and efflorescence was observed in the appearance after PCT. The resist ink composition (5) of Comparative Example 9 containing the phosphorus-free photosensitive resin (6) was inferior in flame retardance.

### EFFECT OF THE INVENTION

Although containing no halogen at all, the flame retardant vinyl ester resin of the present invention can provide a cured product with excellent flame retardance and high heat resistance, moisture-proofness and mechanophysical properties and is excellent in productivity. A flame retardant vinyl ester resin composition of the present invention can satisfy desired flame retardance by mixing vinyl ester resin and unsaturated polyester resin in optional ratios.

### INDUSTRIAL APPLICABILITY

A cured product produced from the flame retardant vinyl ester resin according to the present invention is applicable for electric and electronic parts, especially for a laminated plate and an resist ink, for which excellent flame retardance and high heat resistance, moisture proofness and mechanophysical properties are required.

## Claims

1. A flame retardant vinyl ester containing 0.1 to 6% of phosphorus and 200 to 1000 g/mol double bond equivalent which is obtained by either causing reaction of a compound (A) having epoxy groups with a phosphorus compound of the formula (1) and/or a phosphorus compound of the formula (2) under conditions as to control P-H group/epoxy group ratio to be 0.01 to 0.7 for the former and OH group/epoxy group ratio to be 0.01 to 0.99 for the latter and the total of P-H group/epoxy group ratio and OH group/epoxy group ratio to be 0.99 or lower for both and then reacting the remaining epoxy groups with an ethylenically unsaturated monobasic acid (B), or reacting (A) with (B) and then further reacting the ethylenically unsaturated groups with a phosphorus compound of the formula (1) while controlling the P-H group/double bond ratio to be 0.01 to 0.7, the formula (1) is; 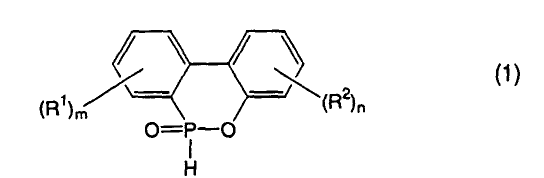 wherein R¹ and R² are the same or different, and separately denote an aliphatic or aromatic group; and the symbols m and n are respectively an integer of 0 to 4 ,the formula of (2) is; 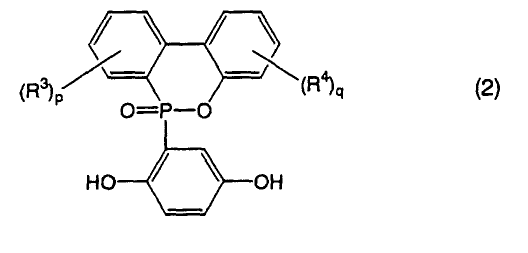 wherein R³ and R⁴ are the same or different, and separately denote an aliphatic or aromatic group; and the symbols p and q are respectively an integer of 0 to 4.

2. The flame retardant vinyl ester according to claim 1, wherein said vinyl ester is obtained by reacting the compound (A) with the phosphorus compound of the formula (1) under conditions as to control P-H group/epoxy group ratio to be 0.01 to 0.7 and/or with the phosphorus compound of the formula (2) in conditions as to control OH group/epoxy group ratio to be 0.01 to 0.99 and the total of P-H group/epoxy group ratio and OH group/epoxy group ratio to be 0.99 or lower and then reacting the remaining epoxy groups with the ethylenically unsaturated monobasic acid (B).

3. The flame retardant vinyl ester according to claim 1, wherein said vinyl ester is obtained by reacting (A) and (B) and then further reacting the ethylenically unsaturated groups with the phosphorus compound having the formula (1) while controlling the P-H group/double bond ratio to be 0.01 to 0.7.

4. The flame retardant vinyl ester according to any one of claims 1, 2, and 3, wherein the compound (A) is at least one compound selected from glycidyl (meth)acrylate, bisphenol A type epoxy resin, bisphenol F type epoxy resin, cresol novolak type epoxy resin, and phenol novolak type epoxy resin.

5. The flame retardant vinyl ester according to any one of claims 1, 2, and 3, wherein the ethylenically unsaturated monobasic acid (B) is either (meth)acrylic acid or a reaction product of at least one compound selected from hydroxyethyl (meth)acrylate, hydroxylpropyl (meth)acrylate, hydroxybutyl (meth)acrylate with a polybasic acid anhydride.

6. The flame retardant vinyl ester according to claim 5, wherein the polybasic acid anhydride is maleic anhydride and/or itaconic anhydride:

7. The flame retardant vinyl ester according to 5, wherein the ethylenically unsaturated monobasic acid (B) is (meth)acrylic acid.

8. The flame retardant vinyl ester resin containing the flame retardant vinyl ester according to claim 1 and a reactive diluent having ethylenically unsaturated bonds.

9. A flame retardant vinyl ester resin composition which comprise 1 to 30 parts by weight of a rubber component to 100 parts by weight in total of the flame retardant vinyl ester according to claim 1 and a reactive diluent having ethylenically unsaturated bonds.

10. A flame retardant vinyl ester resin composition which comprises 0.1 to 5 parts by weight of a curing agent, not more than 400 parts by weight of a filler relative to 100 parts by weight in total of the flame retardant vinyl ester according to claim 1 and a reactive diluent having ethylenically unsaturated bonds.

11. A metal foil-laminated layered plate which comprises a reinforcing fiber layer formed by layering the flame retardant vinyl ester resin according to claim 8 and a metal foil integrally cured together.

12. An acid-adducted flame retardant vinyl ester having a structure in which a polybasic acid anhydride is adducted to at least one of hydroxy groups of the flame retardant vinyl ester according to any one of claims 1, 2, and 3.

13. A photo-curable and thermosetting resist ink composition containing the acid-adducted flame retardant vinyl ester according to claim 12, a diluent, a photopolymerization initiator, and a thermosetting component of an epoxy compound having two or more epoxy groups in one molecule and possible to be developed with an alkaline solution.

14. The resist ink composition according to claim 13 containing the acid-adducted flame retardant vinyl ester as claimed in claim 12 having an acid value of 45 to 160 mgKOH/g.
